# EUROPEAN PATENT APPLICATION

(11) **EP 1 693 974 A1**
(43) Date of publication of application: **23.08.2006**
(21) Application number: 04820114.9
(22) Date of filing: 22.11.2004
(51) Int. Cl.: H04B 10/18, H04B 10/04, H04B 10/06, H03F 3/08

(54) **OPTICAL FIBER RADIO TRANSMISSION SYSTEM, TRANSMISSION DEVICE, AND RECEPTION DEVICE**

(30) Priority: 10.12.2003 JP 2003412368
(71) Applicant: MATSUSHITA ELECTRIC INDUSTRIAL CO., LTD., Kadoma-shi, Osaka 571-8501 (JP)
(72) Inventor: HASE, Kazutoshi, Osaka 570-0021 (JP); YAMAMOTO, Hiroaki, Osaka 536-0017 (JP); UTSUMI, Kuniaki, Hyogo 669-1348 (JP)
(74) Representative: Gassner, Wolfgang
(86) International application number: PCT/JP2004/017355
(87) International publication number: WO 2005/057815

(57) **Abstract**

An optical fiber radio transmission system is provided which is capable of considerably improving the received dynamic range of radio signals and, in addition, is capable of optically transmitting radio signals while preventing the deterioration of transmission performance and the loss of linearity of an input signal more easily. A received level detection section 111 detects which one of predetermined levels, i.e., Level I, Level II, and Level III, the received level of a radio signal received by an antenna 400 falls under. A signal control section 112 performs an amplification/attenuation process on the radio signal in accordance with the detected level. A control information sending section 113 superimposes control information indicating the detected level on a primary signal obtained after the amplification/attenuation process. This signal is converted to an optical signal and transmitted. An optical to electrical conversion section 211 converts the optical signal received from a transmitting unit to an electrical signal. A control information extraction section 212 extracts the level from the control information, which has been superimposed on the primary signal. A signal control section 213 performs an amplification/attenuation process on the primary signal in accordance with the extracted level.

## Description

### TECHNICAL FIELD

The present invention relates to an optical fiber radio transmission system, a transmitting unit, and a receiving unit, and more particularly to an optical fiber radio transmission system, including a transmitting unit (e.g., a remote station) for receiving radio signals via an antenna and a receiving unit (e.g., a base station) connected to each other via an optical fiber, for optically transmitting radio signals via the optical fiber, the system being a transmission system in the optical communications field.

### BACKGROUND ART

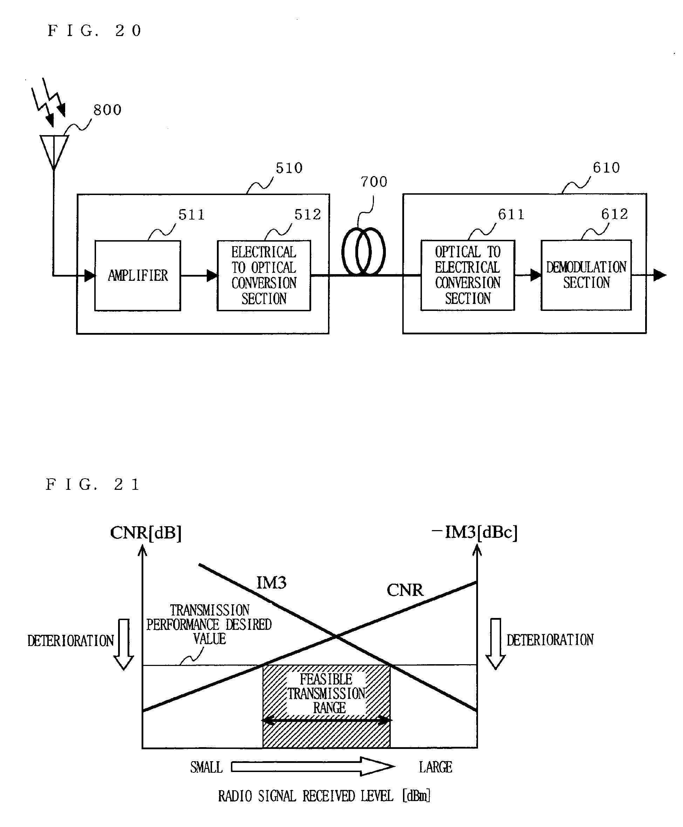

A conventional, generally known configuration of an optical fiber radio transmission system is illustrated in FIG. 20. A transmitting unit 510 and a receiving unit 610 are connected to each other via an optical fiber 700. In the transmitting unit 510, a radio signal received at an antenna 800 is amplified by an amplifier 511 and converted by an electrical to optical conversion section 512 to an optical signal, and thereafter the optical signal is transmitted to the receiving unit 610 via the optical fiber 700, which is a transmission path. In the receiving unit 610, the optical signal transmitted through the optical fiber 700 is converted by an optical to electrical conversion section 611 to an electrical signal, and thereafter a demodulation section 612 performs a predetermined demodulation process on the electrical signal.

Generally known indicators of transmission performance in an optical fiber radio transmission system include a carrier to noise ratio (CNR) and the third order intermodulation distortion (IM3), which have a known relationship therebetween as illustrated in FIG. 21. As is apparent from FIG. 21, if radio signals received at an antenna are too large, deterioration occurs with respect to the IM3, whereas if the radio signals are too small, deterioration occurs with respect to the CNR. In other words, if the received levels of radio signals fall outside a feasible transmission range as illustrated in FIG. 21, the transmission performance deteriorates. Thus, there is a problem in that the received dynamic range of radio signals is narrowed because of the limited feasible transmission range.

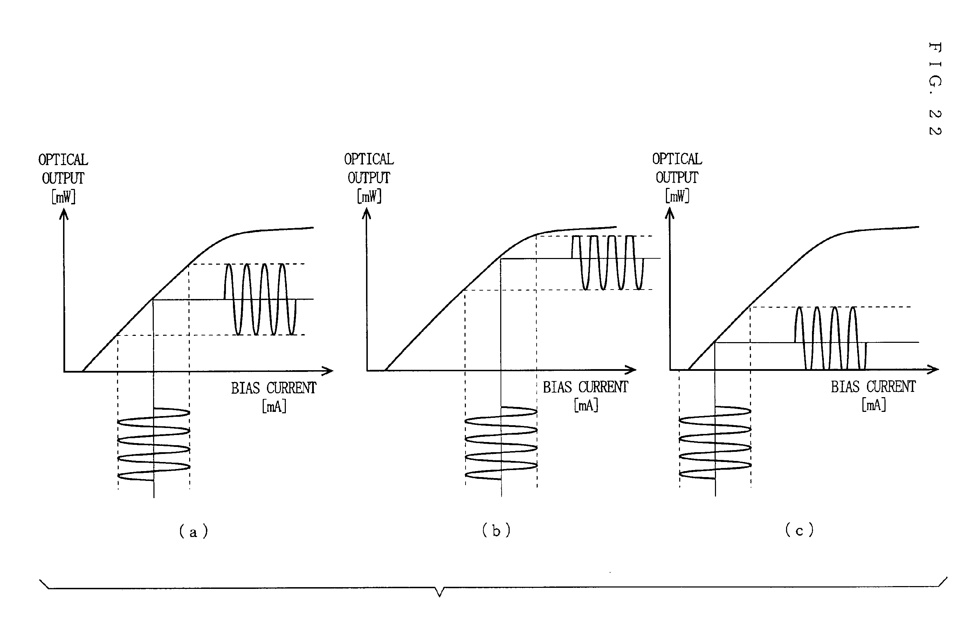

In the optical communications field, when converting a radio signal to an optical signal, a laser diode (LD) is generally employed. It is known that the bias current of the LD and the optical output have relationships as illustrated in FIG. 22. When intensity modulating a radio signal received at an antenna, as illustrated in (b) of FIG. 22, where the bias current is large, the waveform is distorted at the upper portions thereof because the optical output is saturated, which results in inaccurate modulation. Even where the bias current is small, as illustrated in (c) of FIG. 22, accurate modulation cannot be achieved since the optical output becomes zero at some portions, where clipping occurs. Besides such problems derived from the bias current, waveform distortion or clipping is expected to occur when the amplitude of a radio signal is too large. Therefore, in order to achieve accurate modulation of a radio signal, the bias current of an LD is required to be limited to a certain range and, in addition, the amplitude of a radio signal should not be too large. As described above, there has been a problem in that the received dynamic range of radio signals which can be converted to optical signals is narrow.

As a conventional technique to solve such problems, the technique as disclosed in Patent Document 1 is known.

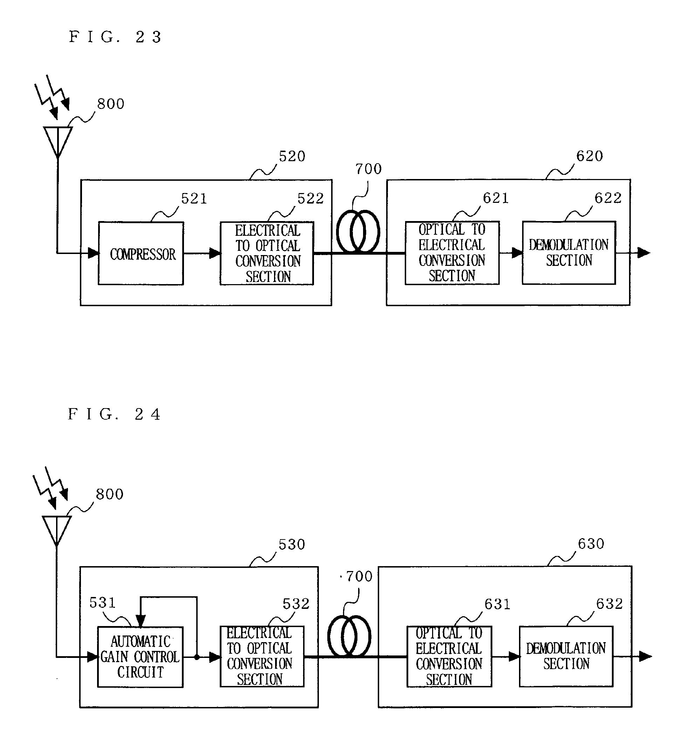

FIG. 23 is a block diagram of a conventional optical fiber radio transmission system disclosed in Patent Document 1. The optical fiber radio transmission system disclosed in Patent Document 1 includes a transmitting unit 520 and a receiving unit 620, which are connected via an optical fiber 700. In the transmitting unit 520, radio signals received at an antenna 800 undergo the compression of received level difference of the radio signals in a compressor 521, converted by an electrical to optical conversion section 522 to optical signals, and thereafter transmitted to the receiving unit 620 via the optical fiber 700, which is a transmission path. In the receiving unit 620, the optical signals transmitted via the optical fiber 700 are converted by an optical to electrical conversion section 621 to electrical signals, and thereafter subjected to a predetermined demodulation process in a demodulation section 622.

As described above, in the optical fiber radio transmission system as disclosed in Patent Document 1, the compressor 521 is employed to compress a high output portion and a low output portion of the radio signals, whereby overall received level difference is made smaller. Thus, improvement is achieved with respect to the deterioration of the CNR.

As another conventional technique which achieves such improvement with respect to the CNR, the technique disclosed in Patent Document 2 is known. FIG. 24 is a block diagram of a conventional optical fiber radio transmission system disclosed in Patent Document 2. The optical fiber radio transmission system disclosed in Patent Document 2 is an optical fiber radio transmission system in which an automatic gain control circuit is employed to achieve constant output of radio signals, and then the output is converted to optical signals. A transmitting unit 530 and a receiving unit 630 are connected via an optical fiber 700. In the transmitting unit 530, radio signals received at an antenna 800 are subjected to feedback control in an automatic gain control circuit 531 to make the levels thereof constant, and, after being converted by an electrical to optical conversion section 532 to optical signals, are transmitted to the receiving unit 630 via the optical fiber 700, which is a transmission path. In the receiving unit 630, the optical signals transmitted via the optical fiber 700 are converted by an optical to electrical conversion section 631 to electrical signals, and thereafter subjected to a predetermined demodulation process in a demodulation section 632.

As described above, in the optical fiber radio transmission system disclosed in Patent Document 2, the automatic gain control circuit 531 is employed to make the levels of radio signals received at the antenna constant, whereby improvement is achieved with respect to the deterioration of the CNR.
Patent Document 1: Japanese Laid-Open Patent Publication No. 10-51391
Patent Document 2: Japanese Patent No. 2596201

### DISCLOSURE OF THE INVENTION

### PROBLEMS TO BE SOLVED BY THE INVENTION

However, in the above conventional optical fiber radio transmission systems, in order to secure a wide received dynamic range of radio signals by employing a compressor (s) or an automatic gain control circuit(s), a high-performance compressor or a high-performance automatic gain control circuit should be employed, or a plurality of compressors or automatic gain control circuits should be employed. This causes problems in that cost is increased or the size of a circuit is increased. Further, because a compressor compresses high output portions or low output portions of radio signals and an automatic gain control circuit makes the levels of radio signals constant, it is expected that the radio signals outputted on the receiving unit side become nonlinear and that deterioration occurs with respect to the IM3, which is distortion characteristics.

Therefore, an object of the present invention is to provide an optical fiber radio transmission systemwhich is capable of achieving considerable improvement in received dynamic range of radio signals and is capable of optically transmitting a radio signal while preventing the deterioration of transmission performance and the loss of linearity of an input signal more easily.

### SOLUTION TO THE PROBLEMS

The present invention is directed to an optical fiber radio transmission system including a transmitting unit for converting a radio signal received via an antenna to an optical signal and sending the optical signal, and a receiving unit for receiving the optical signal sent from the transmitting unit and performing demodulation to obtain the radio signal, in which the transmitting unit and the receiving unit are connected to each other via an optical fiber. To achieve the above object, the optical fiber radio transmission system according to the present invention includes a transmitting unit including a received level detection section, a transmitting signal control section, a control information sending section, and an electrical to optical conversion section, and a receiving unit including an optical to electrical conversion section, a control information extraction section, and a receiving signal control section. It is to be appreciated that each of the transmitting unit and the receiving unit may be employed individually.

In the transmitting unit,the receivedleveldetection section detects a received level of a radio signal received via an antenna. In accordance with the received level detected by the received level detection section, the transmitting signal control section controls an amplification or attenuation process performed on the radio signal received via the antenna. The control information sending section associates control information relating to the received level detected by the received level detection section with the radio signal subjected to control by the transmitting signal control section and sends a resulting signal. The electrical to optical conversion section converts, to an optical signal, the radio signal with which the control information is associated and transmits the optical signal to the receiving unit via an optical fiber.

In the receiving unit, the optical to electrical conversion section converts the optical signal transmitted from the transmitting unit via the optical fiber to an electrical signal. The control information extraction section extracts, from the electrical signal obtained from conversion by the optical to electrical conversion section, the control information, which has been associated with the radio signal and sent by the transmitting unit. Based on the received level obtained from the control information extracted by the control information extraction section, the receiving signal control section controls an amplification or attenuation process to be performed on the electrical signal obtained from conversion by the optical to electrical conversion section so as to counteract against the process performed by the transmitting signal control section.

Typically, the control information sending section superimposes or multiplexes the control information on the radio signal subjected to control by the transmitting signal control section. The control information extraction section separates and extracts from the radio signal the control information, which has been superimposed or multiplexed by the transmitting unit on the radio signal.

Preferably, the control information sending section converts the control information into a value of a voltage and converts the voltage into a predetermined frequency different from a frequency of the radio signal and then superimposes a signal having the predetermined frequency on the radio signal subjected to control by the transmitting signal control section. The control information extraction section extracts only a signal component having the predetermined frequency from the electrical signal obtained from conversion by the optical to electrical conversion section, and converts the extracted frequency into a value of a voltage, thereby extracting the control information.

Also, preferably, the control information sending section converts the control information into a digital value, generates a modulated signal based on the digital value according to a predetermined modulation method, and then superimposes the modulated signal on the radio signal subjected to control by the transmitting signal control section. The control information extraction section demodulates the electrical signal obtained from conversion by the optical to electrical conversion section to obtain a digital signal according to a predetermined demodulation method, and converts the digital signal obtained by demodulation into an analog value, thereby extracting the control information.

Also, preferably, the transmitting unit is further equipped with: a second electrical to optical conversion section for converting an electrical signal outputted from the control information sending section to an optical signal having a wavelength different from a wavelength for the electrical to optical conversion section; and a multiplexing section for multiplexing an optical signal obtained from conversion by the electrical to optical conversion section and an optical signal obtained from conversion by the second electrical to optical conversion section together, and transmitting an optical signal obtained from multiplexing to the receiving unit via the optical fiber, and the control information sending section is caused to convert the control information into a digital value, generate a modulated signal based on the digital value according to a predetermined modulation method, and output the modulated signal to the second electrical to optical conversion section. In addition, the receiving unit may further be equipped with: a dividing section for dividing the optical signal transmitted from the transmitting unit via the optical fiber; and a second optical to electrical conversion section for converting, to an electrical signal, an optical signal having the different wavelength obtained from dividing, and the control information extraction section may be caused to demodulate the electrical signal obtained from conversion by the second optical to electrical conversion section to obtain a digital signal according to a predetermined demodulation method, and convert the digital signal obtained by demodulation into an analog value, thereby extracting the control information.

Also, it is preferable that the predetermined modulation method be one of an amplitude modulation (ASK), a frequency modulation (FSK), and a phase modulation (PSK).

Also, preferably, the control information sending section converts the control information into a digital value, generates a predetermined baseband signal based on the digital value, and then frames the baseband signal and superimposes the framed baseband signal on the radio signal subjected to control by the transmitting signal control section. The control information extraction section extracts the framed digital baseband signal from the electrical signal obtained from conversion by the optical to electrical conversion section, and converts the extracted baseband signal into an analog value, thereby extracting the control information.

Further, preferably, the control information sending section superimposes the control information on the radio signal subjected to control by the transmitting signal control section, by varying a value of a bias current flowing to a light source in the electrical to optical conversion section. The control information extraction section extracts the control information by detecting a value of a driving current flowing to an optical detector in the optical to electrical conversion section.

Typically, the transmitting signal control section and the receiving signal control section as described above each include: a plurality of amplification sections or attenuation sections; and a switch section for, in accordance with the received level detected by the received level detection section, selecting only one section from the plurality of amplification sections or attenuation sections, and determining a processing route for the radio signal received via the antenna.
Also, the transmitting signal control section and the receiving signal control section may each include: a plurality of amplification sections or attenuation sections; and a switch section for, in accordance with the received level detected by the received level detection section, selecting at least two sections from the plurality of amplification sections or attenuation sections, connecting the selected sections in series, and determining a processing route for the radio signal received via the antenna.

It is further preferable that the transmitting signal control section and the receiving signal control section vary an amount of amplification performed on the radio signal or an amount of attenuation performed on the radio signal in a stepwise manner in accordance with the received level.
Also, the received level detection section may output, to the transmitting signal control section and the control information sending section, a received level reflecting a predetermined hysteresis characteristic with respect to the detected received level of the radio signal.

### EFFECT OF THE INVENTION

As described above, according to the present invention, the received dynamic range of radio signals is considerably improved as compared with cases of conventional techniques, and it is possible to optically transmit radio signals while preventing the deterioration of transmission performance and the loss of linearity of an input signal more easily. In addition, the hysteresis effect is employed for switching of amplification/attenuation levels performed by the signal control section. This prevents the levels of radio signals from fluctuating (wavering) even when the radio signals shift so as to cross a boundary between levels, whereby it is made possible to output stable radio signals. Further, control information relating to the received level is superimposed or multiplexed on a primary signal by employing a frequency that is different from a frequency of the primary signal, by varying the bias current for optical signals, by applying ASK modulation, and so on, whereby it is made possible to perform optical transmission easily.

### BRIEF DESCRIPTION OF THE DRAWINGS

[FIG. 1] FIG. 1 is a block diagram illustrating a configuration of an optical fiber radio transmission system according to a first embodiment.
[FIG. 2] FIG. 2 is a diagram illustrating a relationship between the received level of radio signals and a plurality of levels which are previously set.
[FIG. 3] FIG. 3 is a detailed diagram illustrating an exemplary structure of a signal control section 112.
[FIG. 4] FIG. 4 is a diagram illustrating an exemplary input/output characteristic of the signal control section 112.
[FIG. 5] FIG. 5 is a detailed diagram illustrating an exemplary structure of a signal control section 213.
[FIG. 6] FIG. 6 is a diagram illustrating an exemplary input/output characteristic of the signal control section 213.
[FIG. 7A] FIG. 7A is a detailed diagram illustrating other exemplary structures of the signal control sections 112 and 213.
[FIG. 7B] FIG. 7B is a detailed diagram illustrating other exemplary structures of the signal control sections 112 and 213.
[FIG. 8A] FIG. 8A is a detailed diagram illustrating another exemplary structure of the signal control sections 112 and 213.
[FIG. 8B] FIG. 8B is a detailed diagram illustrating another exemplary structure of the signal control sections 112 and 213.
[FIG. 8C] FIG. 8C is a detailed diagram illustrating another exemplary structure of the signal control sections 112 and 213.
[FIG. 9] FIG. 9 is a detailed diagram illustrating another exemplary structure of the signal control sections 112 and 213.
[FIG. 10] FIG. 10 is a block diagram illustrating a configuration of an optical fiber radio transmission system according to a second embodiment of the present invention.
[FIG. 11A] FIG. 11A is a diagram for explaining an exemplary structure and characteristic of a hysteresis received level detection section 121.
[FIG. 11B] FIG. 11B is a diagram for explaining an exemplary structure and characteristic of the hysteresis received level detection section 121.
[FIG. 11C] FIG. 11C is a diagram for explaining an exemplary structure and characteristic of the hysteresis received level detection section 121.
[FIG. 12] FIG. 12 is a block diagram illustrating a configuration of an optical fiber radio transmission system according to a third embodiment of the present invention.
[FIG. 13] FIG. 13 is a diagram for explaining an operation of the optical fiber radio transmission system according to the third embodiment.
[FIG. 14] FIG. 14 is a block diagram illustrating a configuration of an optical fiber radio transmission system according to a fourth embodiment of the present invention.
[FIG. 15] FIG. 15 is a diagram for explaining an operation of the optical fiber radio transmission system according to the fourth embodiment.
[FIG. 16] FIG. 16 is a block diagram illustrating a configuration of an optical fiber radio transmission system according to a fifth embodiment of the present invention.
[FIG. 17] FIG. 17 is a block diagram illustrating a configuration of an optical fiber radio transmission system according to a sixth embodiment of the present invention.
[FIG. 18] FIG. 18 is a block diagram illustrating a configuration of an optical fiber radio transmission system according to a seventh embodiment of the present invention.
[FIG. 19] FIG. 19 is a block diagram illustrating another configuration of the optical fiber radio transmission system according to the seventh embodiment of the present invention.
[FIG. 20] FIG. 20 is a block diagram illustrating a configuration of a conventional optical fiber radio transmission system.
[FIG. 21] FIG. 21 is a diagram for explaining a problem in a conventional optical fiber radio transmission system.
[FIG. 22] FIG. 22 is a diagram for explaining a problem in a conventional optical fiber radio transmission system.
[FIG. 23] FIG. 23 is a block diagram illustrating a configuration of another conventional optical fiber radio transmission system.
[FIG. 24] FIG. 24 is a block diagram illustrating a configuration of another conventional optical fiber radio transmission system.

### DESCRIPTION OF THE REFERENCE CHARACTERS

110-160, 510-530 ··· transmitting unit
111 ··· received level detection section
112, 213 ··· signal control section
112a, 213a, 141 ··· switch section
112b, 213c, 511 ··· amplification section (amplifier)
112c, 213b ··· attenuation section
113 ··· control information sending section
114, 144, 161, 512, 522, 532 ··· electrical to optical conversion section
121 ··· hysteresis received level detection section
131 ··· control voltage conversion section
132 ··· V-f conversion section
142 ··· bias current changing section
151 ··· A/D conversion section
152 ··· ASK modulation section
162, 261 ··· WDM filter
210-260, 610-630 ··· receiving unit
211, 241, 262, 611, 621, 631 ··· optical to electrical conversion section
212, 242 ··· control information extraction section
214, 612, 622, 632 ··· demodulation section
231 ··· lowpass filter (LPF)
232 ··· f-V conversion section
233 ··· highpass filter (HPF)
251 ··· ASK demodulation section
252 ··· D/A conversion section
300, 700 ··· optical fiber
400, 800 ··· antenna
521 ··· compressor
531 ··· automatic gain control circuit

### BEST MODE FOR CARRYING OUT THE INVENTION

Hereinafter, embodiments of the present invention will be described with reference to the drawings.

### [first embodiment]

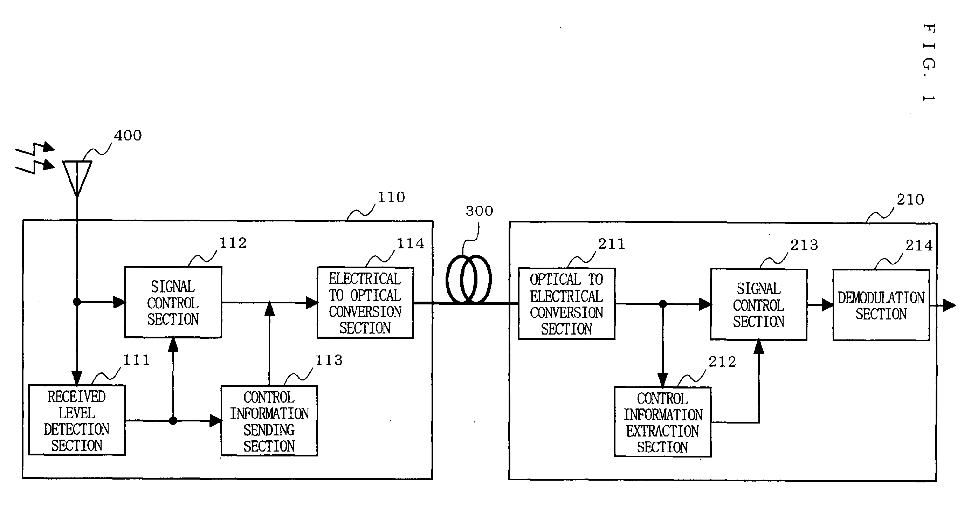

FIG. 1 is a block diagram illustrating a configuration of an optical fiber radio transmission system according to a first embodiment of the present invention. In FIG. 1, the optical fiber radio transmission system according to the first embodiment has a configuration in which a transmitting unit 110 and a receiving unit 210 are connected via an optical fiber 300. The transmitting unit 110 includes a received level detection section 111, a signal control section 112, a control information sending section 113, and an electrical to optical conversion section 114 . The receiving unit 210 includes an optical to electrical conversion section 211, a control information extraction section 212, a signal control section 213, and a demodulation section 214.

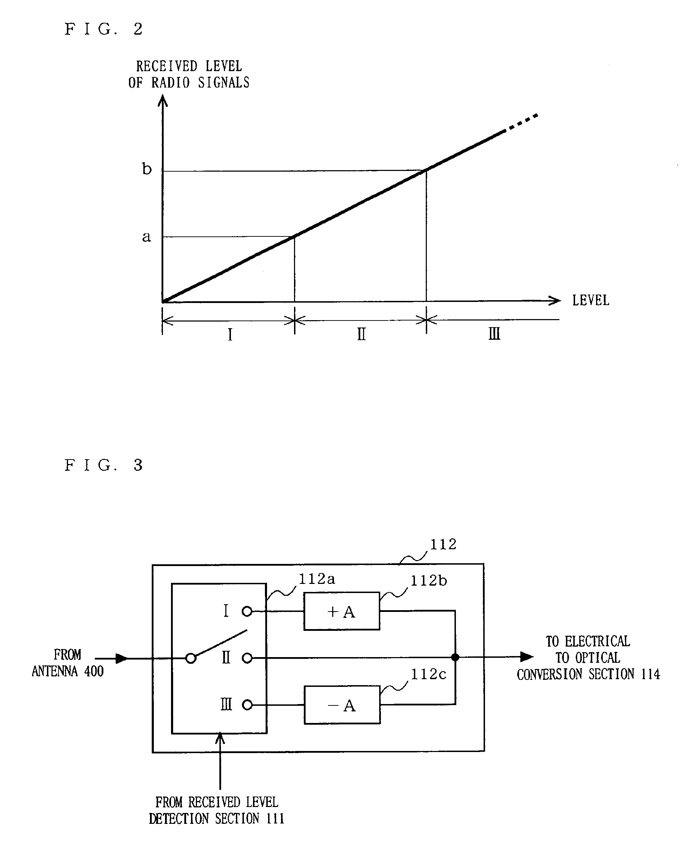

First, operations of the components of the transmitting unit 110 will be described.
The received level detection section 111 detects the received level of a radio signal received at an antenna 400, and determines which of a plurality of levels that have previously been set the received level falls under. The plurality of levels can be set freely in accordance with, for example, a characteristic of the electrical to optical conversion section 114. For example, as illustrated in FIG. 2, if a received level x of a radio signal is low (0<x<a), it is determined that the received level x falls under Level I; if the received level x of a radio signal is intermediate (a≤x<b), it is determined that the received level x falls under Level II; and if the received level x of a radio signal is high (b≤x), it is determined that the received level x falls under Level III. Then, the received level detection section 111 reports the detected received level to the signal control section 112 and the control information sending section 113.

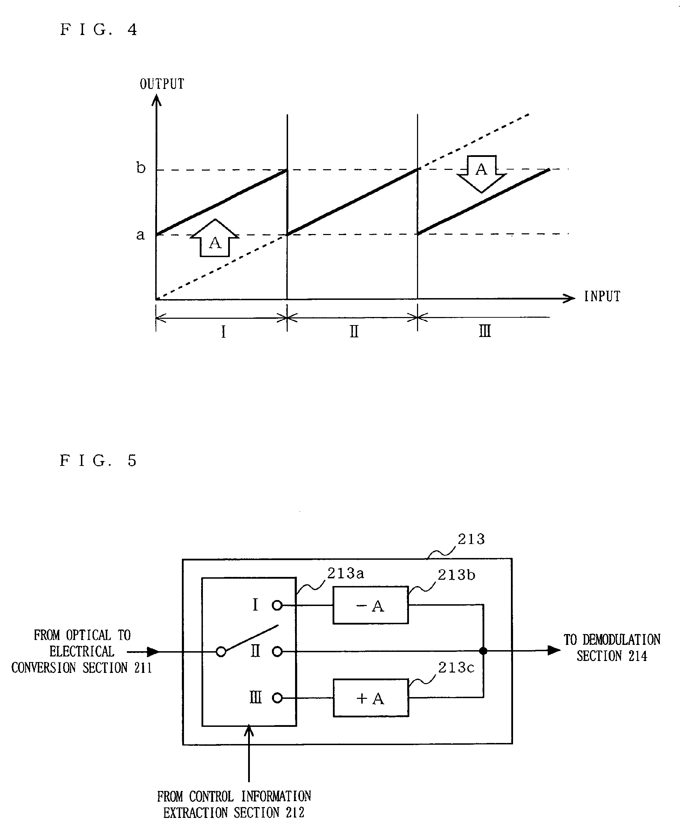

In accordance with the received level reported by the received level detection section 111, the signal control section (transmitting signal control section) 112 performs an amplification/attenuation process on the radio signal received at the antenna 400. As exemplified in FIG. 3, the signal control section 112 is typically composed of a switch section 112a for making a switch between the plurality of predetermined levels, an amplification section 112b for amplifying by a value A [dB], and an attenuation section 112c for attenuating by the value A [dB]. According to the structure illustrated in FIG. 3, in the case of Level I, which corresponds to a low received level, the signal route is switched to a route that includes the amplification section 112b, whereby the signal is amplified; and in the case of Level III, which corresponds to a high received level, the signal route is switched to a route the includes the attenuation section 112c, whereby the signal is attenuated. Needless to say, the signal route in the case of Level II is equivalent to a route that includes an amplification section for one time amplification. That is, the amount of amplification or attenuation for a radio signal is caused to vary in a stepwise manner, in accordance with the received level. As a result, an input/output characteristic of the signal control section 112 as illustrated in FIG. 4 is obtained, and even in the case where the range of the received levels of radio signals that are received at the antenna 400 is wide, deviation from a predetermined range of levels (which corresponds to the range of from a to b in the example of FIG. 4) will not occur. Thus, considerable improvement in receiveddynamic range of radio signals is achieved. Note that it is the most preferable that the value A for the amplification section 112b and the attenuation section 112c be set so that each level in the input/output characteristic will have the same maximum value and the same minimum value as in FIG. 4, in accordance with a characteristic of the electrical to optical conversion section 114 at the subsequent stage.

Upon receiving the report of the received level from the received level detection section 111, the control information sending section 113 superimposes information of the received level, i.e., control information that indicates the level based on which the signal control section 112 has controlled the amplification/attenuation process for the radio signal, on the radio signal (hereinafter referred to as a "primary signal") which has been outputted from the signal control section 112 after the control. Specifically, on a primary signal component that has been amplified based on Level I, control information that indicates Level I is superimposed; on a primary signal component that has been outputted without undergoing amplification or attenuation based on Level II, control information that indicates Level II is superimposed; and on a primary signal component that has been amplified based on Level III, control information that indicates Level III is superimposed.

The electrical to optical conversion section 114 converts to an optical signal the radio signal containing the primary signal and the control information superimposed thereon, and sends the optical signal to the optical fiber 300, which is a transmission path. As described above, the optical signal is generated based on the radio signal whose received level has been controlled to be within the predetermined range of levels. Therefore, the electrical to optical conversion section 114 is capable of generating an optical signal whose waveform does not contain distortion such as saturation, clipping, or the like, regardless of the initial received level of the radio signal. In addition, it is made possible to transmit the generated optical signal which does not contain distortion through the optical fiber 300 while maintaining a high transmission performance.

Next, operations of the components of the receiving unit 210 will be described.
The optical to electrical conversion section 211 receives the optical signal transmitted from the transmitting unit 110 via the optical fiber 300, and converts it to an electrical signal. The radio signal which has been subjected to optical to electrical conversion is inputted to the control information extraction section 212 and the signal control section 213.

The control information extraction section 212 extracts the control information, which had been superimposed by the control information sending section 113 of the transmitting unit 110 on the primary signal. Then, the control information extraction section 212 analyzes the extracted control information to determine the level of the amplification/attenuation process which had been performed on the radio signal, and reports the level to the signal control section 213.

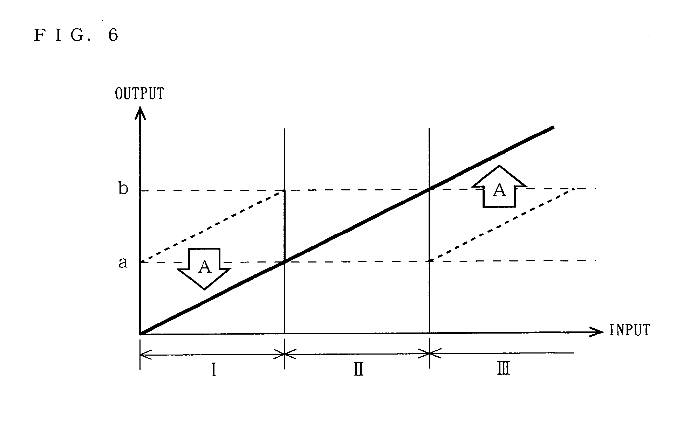

In accordance with the level reported by the control information extraction section 212, the signal control section (receiving signal control section) 213 performs an amplification/attenuation process on the radio signal outputted from the optical to electrical conversion section 211. As exemplified in FIG. 5, the signal control section 213 is typically composed of a switch section 213a for making a switch between the plurality of predetermined levels, an attenuation section 213b for attenuating by the value A [dB], and an amplification section 213c for amplifying by the value A [dB] . This structure corresponds to the structure of the signal control section 112 in the transmitting unit 110, and the plurality of levels and the value A used in the signal control section 213 are set so as to be identical to those which are set in the signal control section 112. According to the structure illustrated in FIG. 5, in the case where the level extracted at the control information extraction section 212 is Level I, the signal route is switched to a route that includes the attenuation section 213b, whereby the signal is attenuated; and in the case of Level III, the signal route is switched to a route that includes the amplification section 213c, whereby the signal is amplified. As a result, an input/output characteristic of the signal control section 213 as illustrated in FIG. 6 is obtained, and a process which counteracts against the amplification/attenuation process performed in the signal control section 112, i.e., a process of reproducing the state of the radio signal received at the antenna 400 of the transmitting unit 110, is performed. In this manner, the receiving unit 210 is able to receive the radio signal which had been received at the transmitting unit 110, without reducing linearity.

Then, the demodulation section 214 performs a predetermined demodulation process on the radio signal which has been subjected to the amplification/attenuation process at the signal control section 213, i.e., the radio signal which had been received at the transmitting unit 110.

As described above, in the optical fiber radio transmission system according to the first embodiment of the present invention, the amplification/attenuation process is performed on a radio signal at the transmitting unit end so that the received level thereof will be within the predetermined range, whereas the amplification/attenuation process that is inverse to that performed at the transmitting unit end is performed on the radio signal at the receiving unit end. Thus, the present invention realizes considerable improvement in the received dynamic range of the radio signal as compared to before, and is capable of optically transmitting a radio signal while preventing the deterioration of transmission performance and the loss of linearity of an input signal more easily.

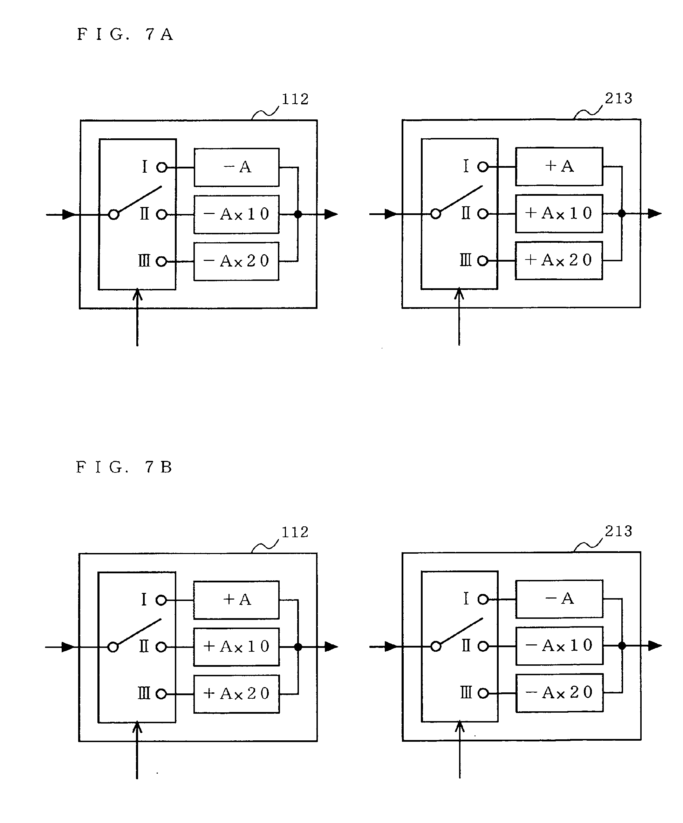

Although the above-described first embodiment has described an exemplary case where the switching which is performed in the signal control section 112 and the signal control section 213 is made between three levels, the number of levels may be other than three. As long as consistency is maintained between the transmitting unit and the receiving unit, arbitrary design is allowed.
Further, the above-described first embodiment has described an exemplary case where each of the signal control section 112 and the signal control section 213 is composed of an amplifier and an attenuator. However, as illustrated in FIG. 7A, it may be so arranged that the signal control section 112 is composed only of attenuators and the signal control section 213 is composed only of amplifiers. Still further, as illustrated in FIG. 7B, it may be so arranged that the signal control section 112 is composed only of amplifiers and the signal control section 213 is composed only of attenuators.

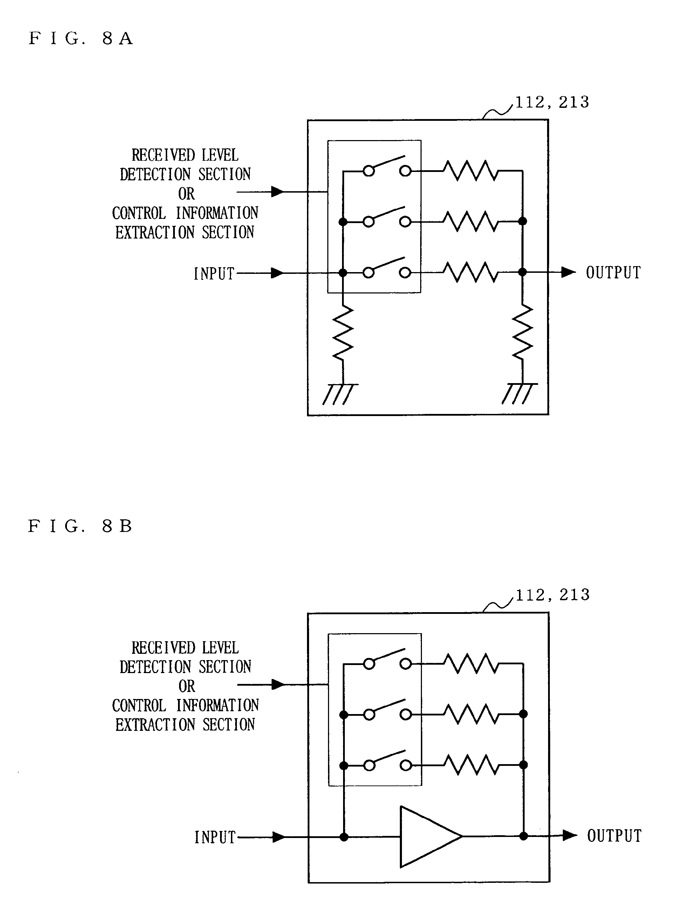

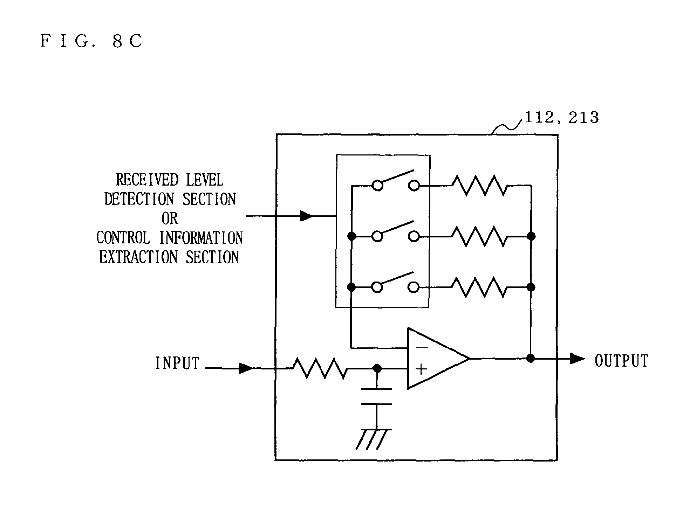

As a specific circuit arrangement for the signal control section 112 and the signal control section 213, as illustrated in FIG. 8A, a processing circuit which uses a π type attenuator or the like is conceivable in which the amount of attenuation is caused to change by changing only a constant, such as a resistance or the like, while using a single primary route. As illustrated in FIG. 8B, a processing circuit is also conceivable in which a negative feedback loop is formed for an amplifier which is applied to a primary route and the constant of a feedback resistance is changed to change the amount of amplification. Further, as illustrated in FIG. 8C, a processing circuit is conceivable in which an operational amplifier is applied to a primary route and a programmable gain amplifier or the like which changes the constant of a feedback resistance to change the amount of amplification is used.

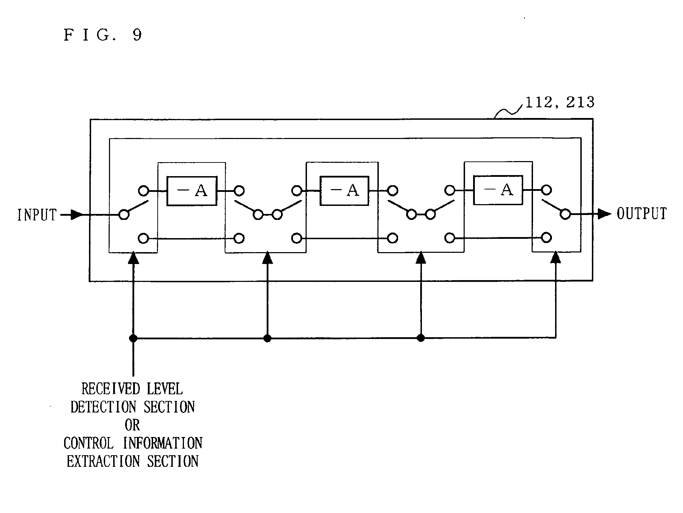

The above-described first embodiment has been described with respect to an exemplary case where the signal control section 112 and the signal control section 213 have a circuit arrangement in which the processing route is switched in a parallel manner. However, as illustrated in FIG. 9, the signal control section 112 and the signal control section 213 may have a circuit arrangement in which the processing route is switched in a serial manner.

### [second embodiment]

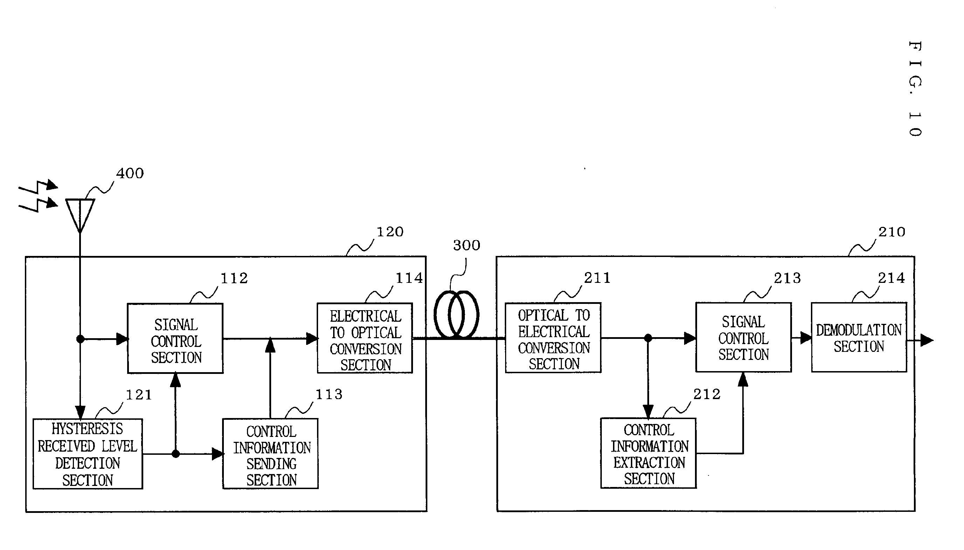

FIG. 10 is a block diagram illustrating a configuration of an optical fiber radio transmission system according to a second embodiment of the present invention. In FIG. 10, the optical fiber radio transmission system according to the second embodiment has a configuration in which a transmitting unit 120 and the receiving unit 210 are connected via the optical fiber 300. The transmitting unit 120 includes a hysteresis received level detection section 121, the signal control section 112, the control information sending section 113, and the electrical to optical conversion section 114. The receiving unit 210 includes the optical to electrical conversion section 211, the control information extraction section 212, the signal control section 213, and the demodulation section 214.

As is apparent from FIG. 10, the optical fiber radio transmission system according to the second embodiment differs from the optical fiber radio transmission system according to the above-described first embodiment in the hysteresis received level detection section 121. Hereinafter, the common components have assigned thereto the same reference numerals as in the first embodiment, and the descriptions thereof are omitted. The optical fiber radio transmitting unit according to the second embodiment will be described with focus on the hysteresis received level detection section 121, which is an alternative component.

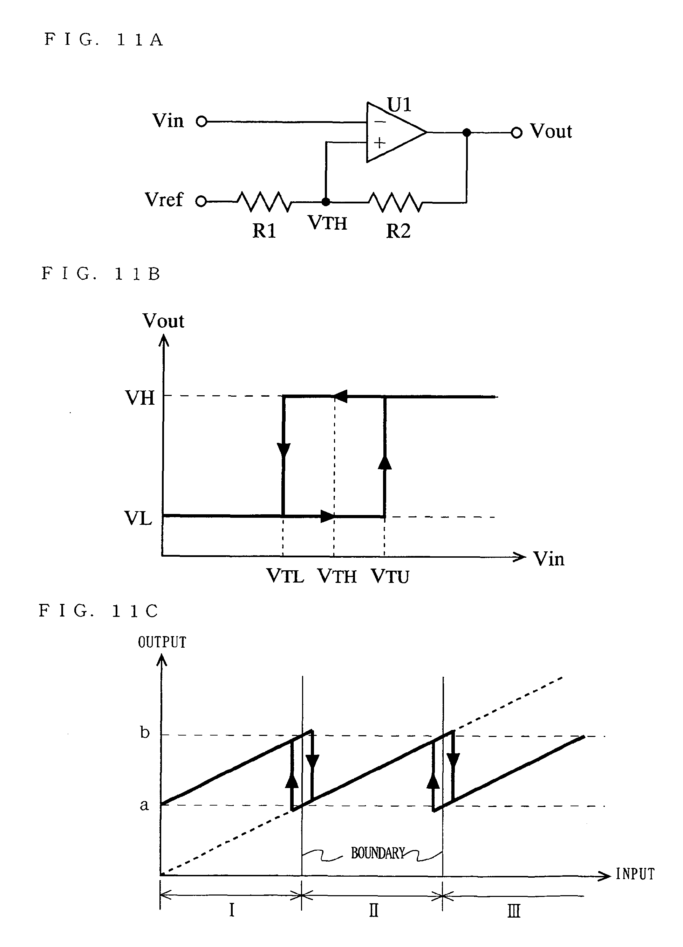

The hysteresis received level detection section 121 detects the received level of a radio signal received at the antenna 400, and determines which of a plurality of levels that have previously been set the received level falls under, while taking account of a predetermined hysteresis effect. The plurality of levels are assumed to be Level I to Level III as illustrated in FIG. 2, which has been described earlier. An example of a circuit which allows the hysteresis effect to work effectively is a circuit in which resistors R1 and R2 are connected to a noninverting input terminal of a commonly-used comparator U1 (FIG. 11A). An operation of this circuit will be described below with reference to FIG. 11B.

Consider, for example, the case where an initial input voltage V₀ satisfies V₀<V_{TL}, an initial output voltage is V_{L}, and the input voltage will gradually increase. In this case, when the input voltage passes a hysteresis lower limit voltage V_{TL} and then a threshold voltage V_{TH} and thereafter reaches a hysteresis upper limit voltage V_{TU}, the output voltage changes from V_{L} to V_{H}. Consider the converse case where the input voltage will gradually decrease, starting from V_{H}. In this case, when the input voltage passes the hysteresis upper limit voltage V_{TU} and then the threshold voltage V_{TH}, and thereafter reaches the hysteresis lower limit voltage V_{TL}, the output voltage changes from V_{H} to V_{L}. A hysteresis width (from V_{TL} to V_{TU}) provided around the threshold voltage V_{TH} as described above serves to stabilize the output voltage, which would undergo considerable change near a boundary between levels in the case of a commonly-used comparator.

An input/output characteristic of the signal control section 112 controlled by the hysteresis received level detection section 121 will be described with reference to FIG. 11C. Consider the case where the received level is currently in the vicinity of the boundary between Level I and Level II. When radio signals shift from Level I to Level II, the hysteresis received level detection section 121 continues to determine the received level to fall under Level I until the received level passes the boundary between Level I and Level II and then reaches a certain level. Accordingly, the selection at the switch section 112a of the signal control section 112 is fixed to Level I. Then, when the received level has reached the certain level (the hysteresis upper limit voltage V_{TU} in FIG. 11B), the hysteresis received level detection section 121 determines the received level to fall under Level II, and the selection at the switch section 112a is switched from Level I to Level II. Conversely, when radio signals shift from Level II to Level I, the hysteresis received level detection section 121 continues to determine the received level to fall under Level II until the received level passes the boundary between Level I and Level II and then reaches a certain level. Accordingly, the selection at the switch section 112a is fixed to Level II. Then, when the received level has reached the certain level (the hysteresis lower limit voltage V_{TL} in FIG. 11B), the hysteresis received level detection section 121 determines the received level to fall under Level I, and the selection at the switch section 112a is switched from Level II to Level I. This operation is also performed with respect to a boundary between Level II and Level III in a similar manner.

As described above, in the optical fiber radio transmission system according to the second embodiment of the present invention, the hysteresis effect is employed for switching of amplification/attenuation levels performed by the signal control section. This prevents the levels of radio signals from fluctuating (wavering) even when the radio signals shift so as to cross a boundary between levels, whereby it is made possible to output stable radio signals.

### [third embodiment]

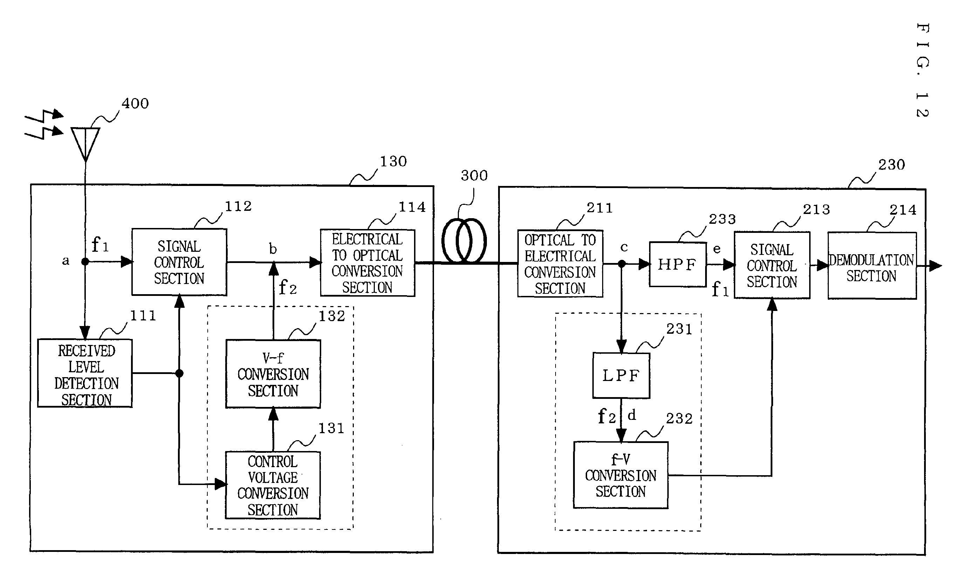

FIG. 12 is a block diagram illustrating a configuration of an optical fiber radio transmission system according to a third embodiment of the present invention. In FIG. 12, the optical fiber radio transmission system according to the third embodiment has a configuration in which a transmitting unit 130 and the receiving unit 230 are connected via the optical fiber 300. The transmitting unit 130 includes the received level detection section 111, the signal control section 112, a control voltage conversion section 131, a V-f conversion section 132, and the electrical to optical conversion section 114. The control voltage conversion section 131 and the V-f conversion section 132 correspond to the control information sending section 113, which has been described in the above-described first embodiment. The receiving unit 230 includes the optical to electrical conversion section 211, a lowpass filter (LPF) 231, an f-V conversion section 232, a highpass filter (HPF) 233, the signal control section 213, and the demodulation section 214. The LPF 231 and the f-V conversion section 232 correspond to the control information extraction section 212, which has been described in the above-described first embodiment.

As illustrated in FIG. 12, the optical fiber radio transmission system according to the third embodiment differs from the optical fiber radio transmission system according to the above-described first embodiment in the control voltage conversion section 131, the V-f conversion section 132, the LPF 231, the f-V conversion section 232, and the HPF 233. Hereinafter, the common components have assigned thereto the same reference numerals as in the first embodiment, and the descriptions thereof are omitted. The optical fiber radio transmitting unit according to the third embodiment will be described with focus on the alternative components.

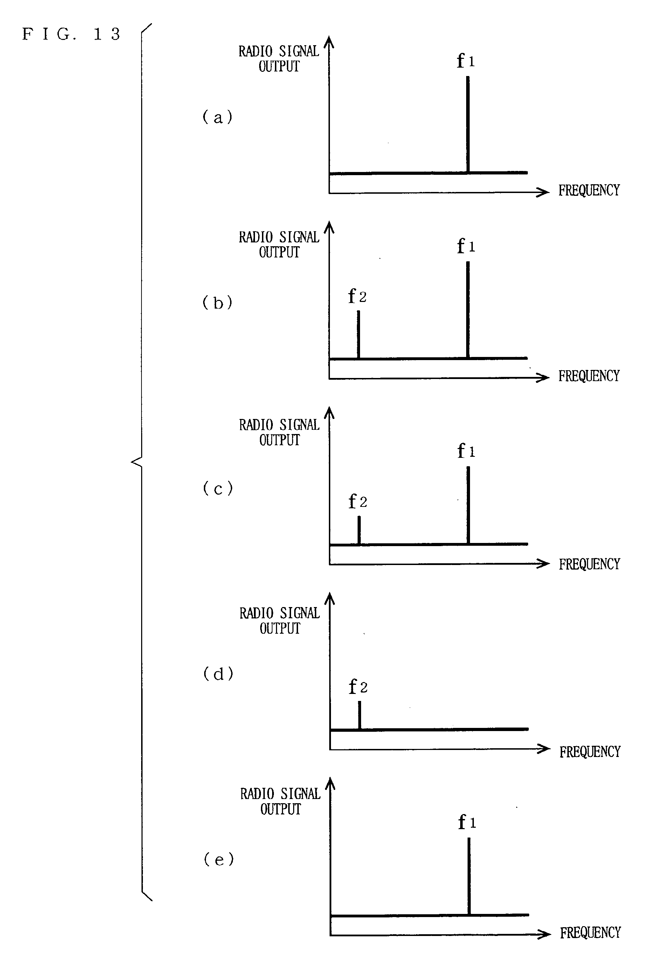

Let f₁ denote the frequency of a radio signal received at the antenna 400 in the transmitting unit 130. Then, the radio signal as illustrated in (a) of FIG. 13 is outputted at point a in FIG. 12. The received level of the radio signal detected by the received level detection section 111 is outputted to the signal control section 112 to be used for the switching in the amplification/attenuation process, and, in addition, is converted to a control voltage in the control voltage conversion section 131. The V-f conversion section 132 converts the control voltage outputted from the control voltage conversion section 131 to a signal having a frequency of f₂ (which is one of f_{I}, f_{II}, and f_{III} depending on the value of the control voltage), and the signal having the frequency f₂ is superimposed on the primary signal. As a result, an electrical signal having the frequency f₁ and the frequency f₂ as illustrated in (b) of FIG. 13 is outputted at point b in FIG. 12. This electrical signal is converted to an optical signal in the electrical to optical conversion section 114, which is sent to the optical fiber 300.

In the receiving unit 230, the optical to electrical conversion section 211 converts the optical signal received via the optical fiber 300 to an electrical signal. As a result, an electrical signal whose signal level has been reduced because of a loss in the optical fiber 300 or the like, as illustrated in (c) of FIG. 13, is obtained at point c in FIG. 12. The HPF 233 extracts from this electrical signal only a component having the frequency f₁, and supplies the component to the signal control section 213. Meanwhile, the LPF 231 extracts from the electrical signal only a component having the frequency f₂, and the component is inputted to the f-V conversion section 232. As a result, signals obtained by extracting either one of the two frequencies are obtained at point d and point e in FIG. 12, as illustrated in (d) of FIG. 13 and (e) of FIG. 13, respectively. Then, the f-V conversion section 232 converts to a control voltage the signal having the frequency f₂ extracted in the LPF 231, and outputs the control voltage to the signal control section 213.

As described above, in the optical fiber radio transmission system according to the third embodiment of the present invention, control information relating to the received level is superimposed on the primary signal such that the control information has a frequency different from the frequency of the radio signal, and the resulting signal is transmitted. This makes it possible to easily superimpose the control information on the primary signal and optically transmit the resulting signal.

### [fourth embodiment]

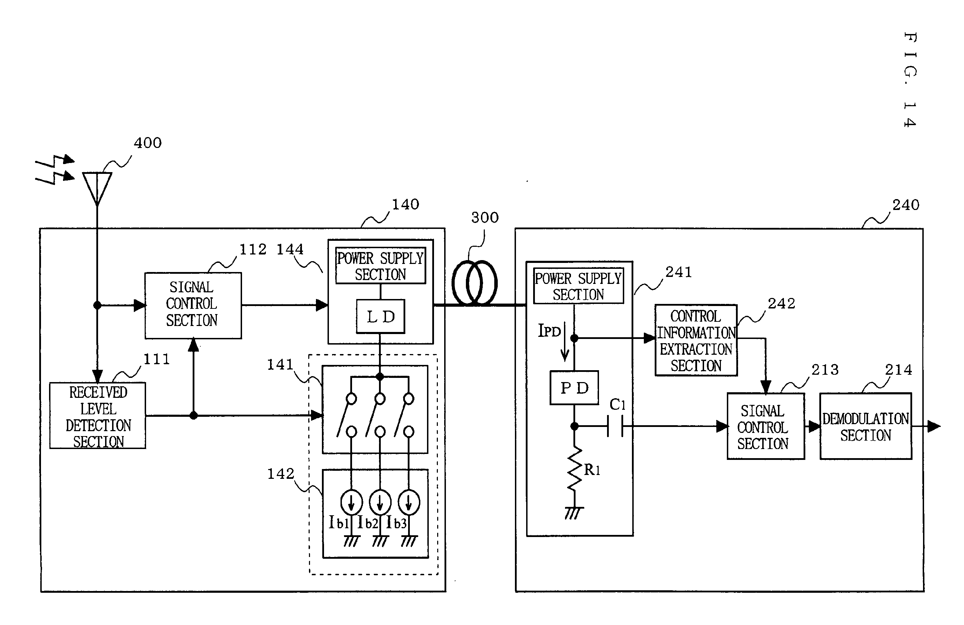

FIG. 14 is a block diagram illustrating a configuration of an optical fiber radio transmission system according to a fourth embodiment of the present invention. In FIG. 14, the optical fiber radio transmission system according to the fourth embodiment has a configuration in which a transmitting unit 140 and a receiving unit 240 are connected via the optical fiber 300. The transmitting unit 140 includes the received level detection section 111, the signal control section 112, a switch section 141, a bias current changing section 142, and an electrical to optical conversion section 144. The switch section 141 and the bias current changing section 142 correspond to the control information sending section 113, which has been described in the above-described first embodiment. The receiving unit 240 includes an optical to electrical conversion section 241, a control information extraction section 242, the signal control section 213, and the demodulation section 214.

As illustrated in FIG. 14, the optical fiber radio transmission system according to the fourth embodiment differs from the optical fiber radio transmission system according to the above-described first embodiment in the switch section 141, the bias current changing section 142, the electrical to optical conversion section 144, the optical to electrical conversion section 241, and the control information extraction section 242. Hereinafter, the common components have assigned thereto the same reference numerals as in the first embodiment, and the descriptions thereof are omitted. The optical fiber radio transmitting unit according to the fourth embodiment will be described with focus on the alternative components.

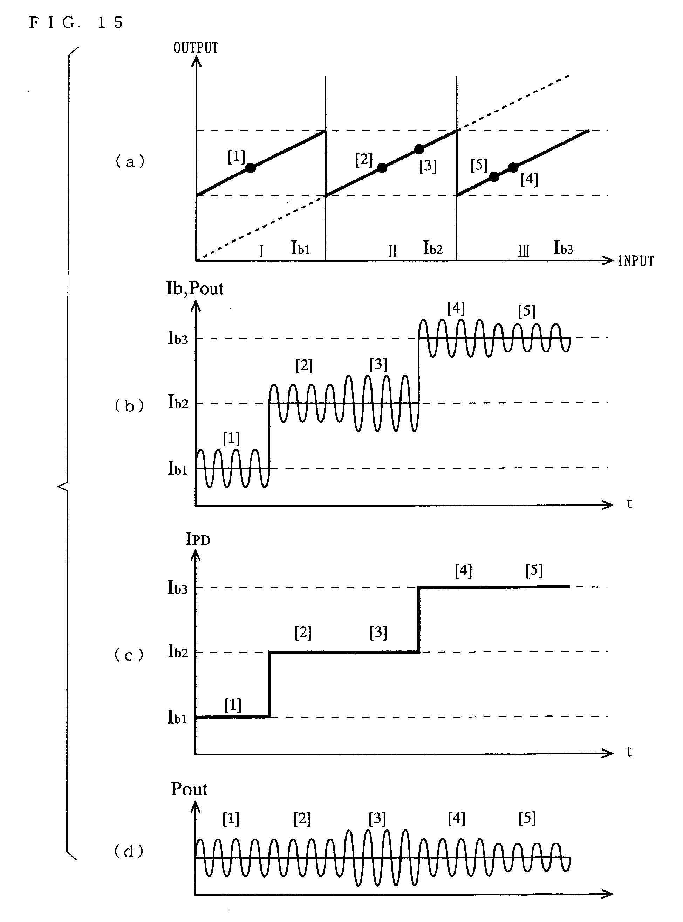

As described in the above-described first embodiment, the input/output characteristic of the signal control section 112 in the transmitting unit 140 is represented by (a) of FIG. 15. The electrical to optical conversion section 144, which is typically composed of a power supply section for supplying a driving current and a laser diode (LD), generates an optical signal by supplying to the LD a driving current that corresponds to the level of the radio signal outputted from the signal control section 112. The switch section 141 is a switch with one input and three outputs, and the input terminal thereof is connected to a cathode terminal of the LD. The bias current changing section 142 has three bias current sources corresponding to mutually different current amounts, and each of the three bias current sources is connected to a separate one of the three output terminals of the switch section 141. The number of switching switches in the switch section 141 and the number of bias current sources in the bias current changing section 142 are set so as to correspond with the number of levels which is set in the received level detection section 111 and the signal control section 112.

The received level detection section 111 reports the detected received level to the switch section 141. In accordance with the reported received level of the radio signal, the switch section 141 selects one of three output lines, thereby connecting the cathode terminal of the LD to one of the bias current sources in the bias current changing section 142. As a result, in accordance with the received level of the radio signal, one of bias currents Ib₁, Ib₂, and Ib₃ flows to the LD.

An example of an optical signal which is outputted from the electrical to optical conversion section 144 after the above processing will be described with reference to the case where the bias currents satisfy the relationship Ib₁<Ib₂<Ib₃, and the setting is made such that the bias current Ib₁ is selected when the radio signal falls under Level I, the bias current Ib₂ is selected when the radio signal falls under Level II, and the bias current Ib₃ is selected when the radio signal falls under Level III. The relationship between the bias currents is not limited to that of this example, and may be set arbitrarily.

In the case where the setting is made as above, when the radio signal sequentially changes from [1] to [5] indicated in (a) of FIG. 15, the bias current Ib and the radio signal output Pout change with time in a manner as illustrated in (b) of FIG. 15. First, when the radio signal is in the state [1], the bias current is Ib₁, and the amplitude of the radio signal is assumed to be A. Then, when the state has changed from [1] to [2], the radio signal falls under Level II as illustrated in (a) of FIG. 15; therefore, the connection in the switch section 141 is switched so that the bias current becomes Ib₂, and because the output of the radio signal is substantially the same as that when the state is [1], the amplitude of the radio signal is the amplitude A. Then, when the state has changed from [2] to [3], the bias current Ib does not change, and because when the state is [3], the output of the radio signal is greater than that when the state is [2], the amplitude of the radio signal becomes higher than the amplitude A. Then, when the state has changed from [3] to [4], the radio signal falls under Level III as illustrated in (a) of FIG. 15; therefore, the bias current changes from Ib₂ to Ib₃, and the amplitude of the radio signal becomes the amplitude A, which is substantially the same as that when the state is [1] or [2] . Then, when the state has changed from [4] to [5], the bias current Ib does not change, and because when the state is [5], the output of the radio signal is less than that when the state is [4], the amplitude of the radio signal becomes lower than the amplitude A.

The optical to electrical conversion section 241 in the receiving unit 240 is typically composed of a power supply section for supplying a current I_{PD}, a photodiode (PD), a resistor R₁, and a capacitor C₁. The optical signal sent from the transmitting unit 140 is received by the PD via the optical fiber 300. The PD receives a current I_{PD} corresponding to the intensity of the received optical signal, the current I_{PD} being supplied from the power supply section. Specifically, the current I_{PD} depends on the intensity of the optical signal such that as this intensity increases, the current I_{PD} that flows from the power supply section becomes larger in magnitude, whereas as the intensity decreases, the current I_{PD} that flows from the power supply section becomes smaller in magnitude. The intensity of the optical signal depends on the magnitude of the bias current as described earlier. Therefore, measuring the current I_{PD} makes it possible to determine the magnitude of the bias current, i.e., whether the bias current selected at the switch section 141 and the bias current changing section 142 in the transmitting unit 140 is Ib₁, Ib₂, or Ib₃.

The control information extraction section 242 detects the amount of flow of the current I_{PD} supplied from the power supply section to the PD, and determines which of Ib₁, Ib₂, or Ib₃ the bias current is ((c) of FIG. 15). This determination can be easily made by using a threshold x that satisfies Ib₁<x<Ib₂ and a threshold y that satisfies Ib₂<y<Ib₃. Then, the control information extraction section 242 determines that the level of the amplification/attenuation process that has been performed on the radio signal is Level I if the bias current is Ib₁, Level II if the bias current is Ib₂, and Level III if the bias current is Ib₃, and reports the determination result to the signal control section 213. Various methods are conceivable for detecting the current I_{PD}, e.g., a method of directly detecting the current I_{PD} by means of a current mirror circuit, a method of indirectly detecting the current I_{PD} by employing a constant-current source to form the power supply section and determining the amount of a current other than the current I_{PD} that flows to the PD, or the like.

The capacitor C₁ in the optical to electrical conversion section 241 has a function of blocking a direct-current signal. Therefore, as illustrated in (d) of FIG. 15, only a radio signal that is an alternating current signal is inputted to the signal control section 213. Thus, it is made possible to output a radio signal corresponding to the radio signal received on the transmitting unit 140 side by selecting an appropriate processing route in the signal control section 213.

As described above, in the optical fiber radio transmission system according to the fourth embodiment of the present invention, control information relating to the received level is superimposed on the primary signal by varying the bias current for the optical signal. This makes it possible to easily superimpose the control information on the primary signal and optically transmits the resulting signal.

### [fifth embodiment]

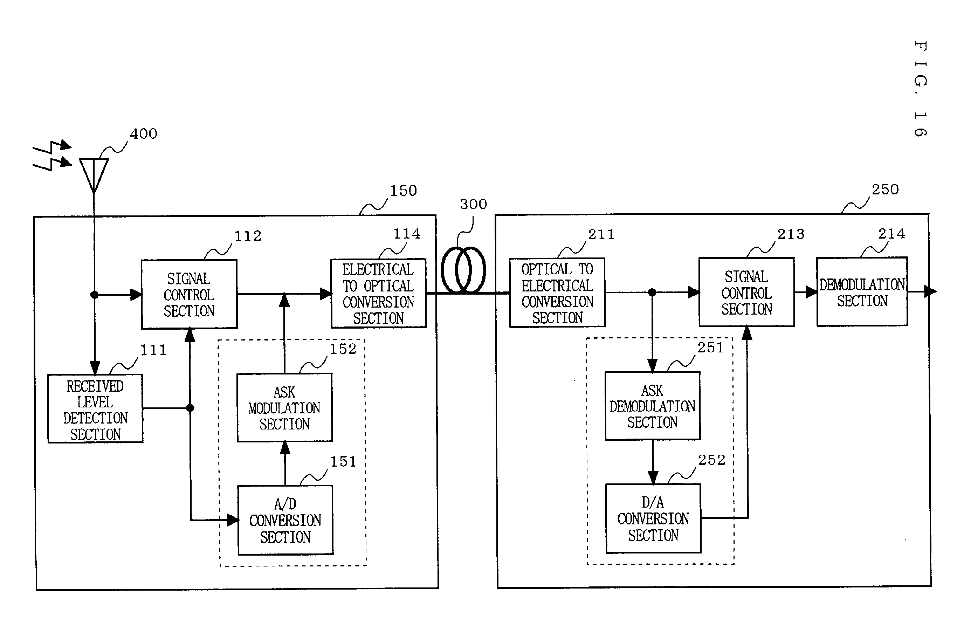

FIG. 16 is a block diagram illustrating a configuration of an optical fiber radio transmission system according to a fifth embodiment of the present invention. In FIG. 16, the optical fiber radio transmission system according to the fifth embodiment has a configuration in which a transmitting unit 150 and a receiving unit 250 are connected via the optical fiber 300. The transmitting unit 150 includes the received level detection section 111, the signal control section 112, an A/D conversion section 151, an ASK modulation section 152, and the electrical to optical conversion section 114. The A/D conversion section 151 and the ASKmodulation section 152 correspond to the control information sending section 113, which has been described in the above-described first embodiment. The receiving unit 250 includes the optical to electrical conversion section 211, an ASK demodulation section 251, a D/A conversion section 252, the signal control section 213, and the demodulation section 214. The ASK demodulation section 251 and the D/A conversion section 252 correspond to the control information extraction section 212, which has been described in the above-described first embodiment.

As illustrated in FIG. 16, the optical fiber radio transmission system according to the fifth embodiment differs from the optical fiber radio transmission system according to the above-described first embodiment in the A/D conversion section 151, the ASK modulation section 152, the ASK demodulation section 251, and the D/A conversion section 252. Hereinafter, the common components have assigned thereto the same reference numerals as in the first embodiment, and the descriptions thereof are omitted. The optical fiber radio transmitting unit according to the fifth embodiment will be described with focus on the alternative components.

In the transmitting unit 150, the received level of a radio signal detected by the received level detection section 111 is reported to the signal control section 112 and the A/D conversion section 151. The A/D conversion section 151 converts an analog value of the received level to a digital value, and generates a digital control signal. The ASK modulation section 152 performs amplitude modulation (ASK; Amplitude Shift Keying) on the digital control signal, and superimposes the ASK-modulated signal on the primary signal.

In the receiving unit 250, the optical to electrical conversion section 211 converts an optical signal received via the optical fiber 300 to an electrical signal. The electrical signal obtained from the conversion is inputted to the signal control section 213 and the ASK demodulation section 251. The ASK demodulation section 251 performs ASK demodulation on the electrical signal and extracts the digital control signal superimposed on the primary signal. The D/A conversion section 252 converts the extracted digital control signal to an analog value, and outputs a level obtained from this conversion to the signal control section 213.

As described above, in the optical fiber radio transmission system according to the fifth embodiment of the present invention, control information relating to the received level is superimposed on the primary signal through ASK modulation, and the resulting signal is transmitted. This makes it possible to easily superimpose the control information on the primary signal and optically transmit the resulting signal.

### [sixth embodiment]

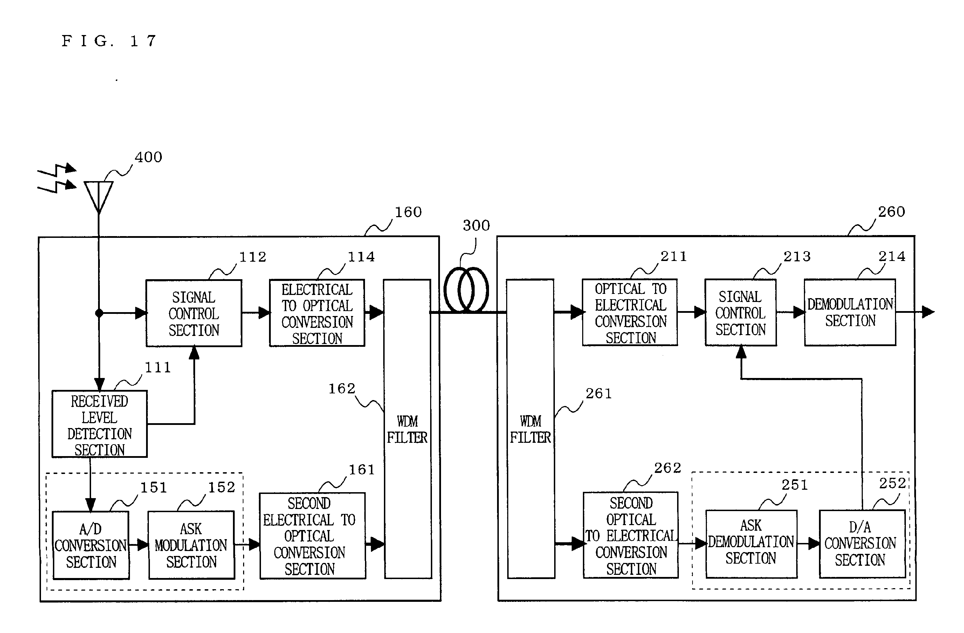

FIG. 17 is a block diagram illustrating a configuration of an optical fiber radio transmission system according to a sixth embodiment of the present invention. In FIG. 17, the optical fiber radio transmission system according to the sixth embodiment has a configuration in which a transmitting unit 160 and a receiving unit 260 are connected via the optical fiber 300. The transmitting unit 160 includes the received level detection section 111, the signal control section 112, the A/D conversion section 151, the ASK modulation section 152, the electrical to optical conversion section 114, a second electrical to optical conversion section 161, and a WDM filter 162. The receiving unit 260 includes a WDM filter 261, the optical to electrical conversion section 211, a second optical to electrical conversion section 262, the ASK demodulation section 251, the D/A conversion section 252, the signal control section 213, and the demodulation section 214.

As illustrated in FIG. 17, the optical fiber radio transmission system according to the sixth embodiment differs from the optical fiber radio transmission system according to the above-described fifth embodiment in the second electrical to optical conversion section 161, the WDM filter 162, the WDM filter 261, and the second optical to electrical conversion section 262. Hereinafter, the common components have assigned thereto the same reference numerals as in the fifth embodiment, and the descriptions thereof are omitted. The optical fiber radio transmitting unit according to the sixth embodiment will be described with focus on the alternative components.

The second electrical to optical conversion section 161 and the second optical to electrical conversion section 262 are conversion circuits that employ a wavelength that is different from that employed by the electrical to optical conversion section 114 and the optical to electrical conversion section 211. The WDM filter 162 and the WDM filter 261 are filters that have a function of multiplexing/dividing a wavelength.

In the transmitting unit 160, the digital control signal, whose received level has been subjected to amplitude modulation in the ASK modulation section 152, is outputted to the second electrical to optical conversion section 161. The second electrical to optical conversion section 161 converts the digital control signal subjected to amplitude modulation to an optical signal whose wavelength is different from that of the primary signal. The WDM filter 162 multiplexes the optical signal that is the primary signal outputted from the electrical to optical conversion section 114 and the optical signal that is the digital control signal outputted from the second electrical to optical conversion section 161 together, and sends the resulting signal to the optical fiber 300.

In the receiving unit 260, the WDM filter 261 divides the optical signal transmitted through the optical fiber 300, and outputs the optical signal that is the primary signal to the optical to electrical conversion section 211, and the optical signal that is the digital control signal to the second optical to electrical conversion section 262. The second optical to electrical conversion section 262 converts the inputted optical signal to an electrical signal, and thereafter outputs the electrical signal to the ASK demodulation section 251.

As described above, in the optical fiber radio transmission system according to the sixth embodiment of the present invention, a signal obtained by subjecting control information relating to the received level to ASK modulation is multiplexed with the primary signal, and the resulting signal is transmitted. This makes it possible to easily multiplex the control information with the primary signal and to optically transmit the resulting signal.

The above-described fifth and sixth embodiments have been described with respect to an exemplary case where the ASK system is adopted as a modulation/demodulation system. However, the present invention is also capable of employing a frequency modulation system (FSK; Frequency Shift Keying) or a phase modulation system (PSK; Phase Shift Keying) in a similar manner. Further, the present invention can also be implemented in a similar manner by adopting an arrangement in which signals are framed employing a base-band digital signal, which is not subjected to modulation, and thereafter the framed signals are transmitted, without employing a modulator or a demodulator.

### [seventh embodiment]

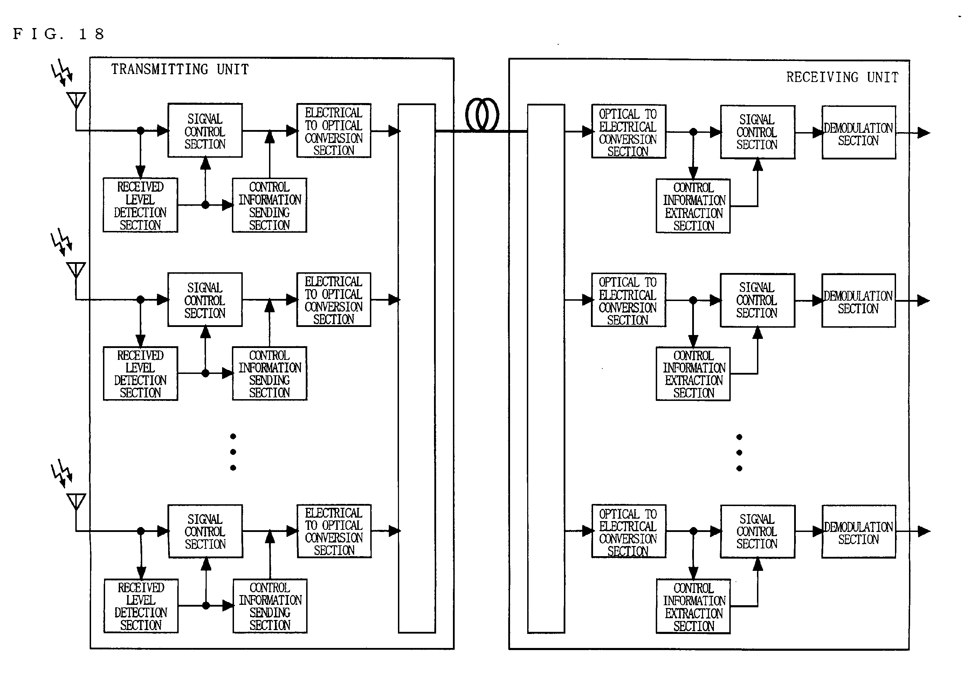

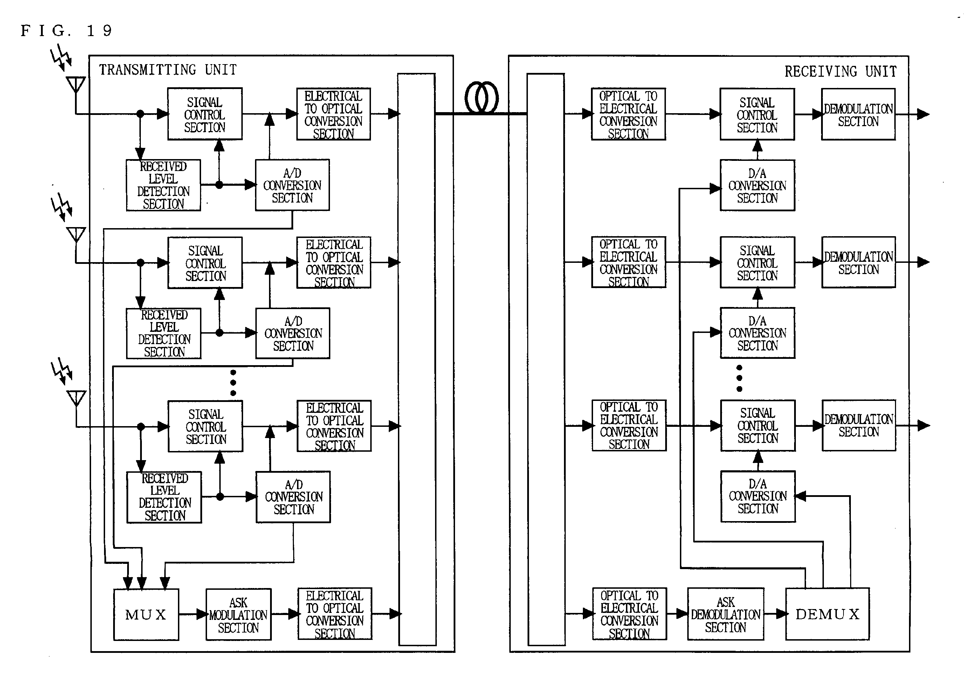

The above-described first to sixth embodiments have been described with respect to the case where the transmitting unit and the receiving unit each have only one primary signal transmission route. However, as illustrated in FIG. 18 and FIG. 19, the transmitting unit and the receiving unit each may have a plurality of primary signal transmission routes. In this case, on the transmitting unit side, a plurality of pieces of control information which are separately detected at each primary signal transmission route may be multiplexed together for a single control information transmission route and then transmitted, whereas on the receiving unit side, the pieces of control information, which have been multiplexed together and then transmitted, may be divided and separately processedin each primarysignal transmission route. Thus, the above-described effects can be achieved in a similar manner.

### INDUSTRIAL APPLICABILITY

The present invention is applicable to, e.g., an optical fiber radio transmission system in which a transmitting unit and a receiving unit are connected via an optical fiber and a radio signal is optically transmitted via the optical fiber, and is particularly suitable for, e.g., the case where there is a desire for considerable improvement in the received dynamic range of a radio signal and for a radio signal to be optically transmitted while preventing the deterioration of transmission performance and the loss of linearity of an input signal more easily.

## Claims

**1.** An optical fiber radio transmission system including a transmitting unit for converting a radio signal received via an antenna to an optical signal and sending the optical signal, and a receiving unit for receiving the optical signal sent from the transmitting unit and performing demodulation to obtain the radio signal, the transmitting unit and the receiving unit being connected to each other via an optical fiber, wherein,
the transmitting unit includes:
a received level detection section for detecting a received level of a radio signal received via an antenna;
a transmitting signal control section for, in accordance with the received level detected by the received level detection section, controlling an amplification or attenuation process performed on the radio signal received via the antenna;
a control information sending section for associating control information relating to the received level detected by the received level detection section with the radio signal subjected to control by the transmitting signal control section and sending a resulting signal; and
an electrical to optical conversion section for converting, to an optical signal, the radio signal with which the control information is associated and transmitting the optical signal to the receiving unit via the optical fiber, and
the receiving unit includes:
an optical to electrical conversion section for converting the optical signal transmitted from the transmitting unit via the optical fiber to an electrical signal;
a control information extraction section for extracting, from the electrical signal obtained from conversion by the optical to electrical conversion section, the control information, which has been associated with the radio signal and sent by the transmitting unit; and
a receiving signal control section for, based on the received level obtained from the control information extracted by the control information extraction section, controlling an amplification or attenuation process performed on the electrical signal obtained from conversion by the optical to electrical conversion section so as to counteract against the process performed by the transmitting signal control section.

**2.** The optical fiber radio transmission system according to claim 1, wherein,
the control information sending section superimposes or multiplexes the control information on the radio signal subjected to control by the transmitting signal control section, and
the control information extraction section separates and extracts the control information from the radio signal, the control information having been superimposed or multiplexed by the transmitting unit on the radio signal.

**3.** The optical fiber radio transmission system according to claim 2, wherein,
the control information sending section converts the control information into a value of a voltage and converts the voltage into a predetermined frequency different from a frequency of the radio signal and then superimposes a signal having the predetermined frequency on the radio signal subjected to control by the transmitting signal control section, and
the control information extraction section extracts only a signal component having the predetermined frequency from the electrical signal obtained from conversion by the optical to electrical conversion section, and converts the extracted frequency into a value of a voltage, thereby extracting the control information.

**4.** The optical fiber radio transmission system according to claim 2, wherein,
the control information sending section converts the control information into a digital value, generates a modulated signal based on the digital value according to a predetermined modulation method, and then superimposes the modulated signal on the radio signal subjected to control by the transmitting signal control section, and
the control information extraction section demodulates the electrical signal obtained from conversion by the optical to electrical conversion section to obtain a digital signal according to a predetermined demodulation method, and converts the digital signal obtained by demodulation into an analog value, thereby extracting the control information.

**5.** The optical fiber radio transmission system according to claim 2, wherein,
the transmitting unit further includes:
a second electrical to optical conversion section for converting an electrical signal outputted from the control information sending section to an optical signal having a wavelength different from a wavelength for the electrical to optical conversion section; and
a multiplexing section for multiplexing an optical signal obtained from conversion by the electrical to optical conversion section and an optical signal obtained from conversion by the second electrical to optical conversion section together, and transmitting an optical signal obtained by multiplexing to the receiving unit via the optical fiber,
the control information sending section converts the control information into a digital value, generates a modulated signal based on the digital value according to a predetermined modulation method, and outputs the modulated signal to the second electrical to optical conversion section,
the receiving unit further includes:
a dividing section for dividing the optical signal transmitted from the transmitting unit via the optical fiber; and
a second optical to electrical conversion section for converting, to an electrical signal, an optical signal having the different wavelength obtained by dividing, and
the control information extraction section demodulates the electrical signal obtained from conversion by the second optical to electrical conversion section to obtain a digital signal according to a predetermined demodulation method, and converts the digital signal obtained by demodulation into an analog value, thereby extracting the control information.

**6.** The optical fiber radio transmission system according to claim 4, wherein the predetermined modulation method is one of an amplitude modulation (ASK), a frequency modulation (FSK), and a phase modulation (PSK).

**7.** The optical fiber radio transmission system according to claim 5, wherein the predetermined modulation method is one of an amplitude modulation (ASK), a frequency modulation (FSK), and a phase modulation (PSK).

**8.** The optical fiber radio transmission system according to claim 2, wherein,
the control information sending section converts the control information into a digital value, generates a predetermined baseband signal based on the digital value, and then frames the baseband signal and superimposes the framed baseband signal on the radio signal subjected to control by the transmitting signal control section, and
the control information extraction section extracts the framed digital baseband signal from the electrical signal obtained from conversion by the optical to electrical conversion section, and converts the extracted baseband signal into an analog value, thereby extracting the control information.

**9.** The optical fiber radio transmission system according to claim 2, wherein,
the control information sending section superimposes the control information on the radio signal subjected to control by the transmitting signal control section, by varying a value of a bias current flowing to a light source in the electrical to optical conversion section, and
the control information extraction section extracts the control information by detecting a value of a driving current flowing to an optical detector in the optical to electrical conversion section.

**10.** The optical fiber radio transmission system according to claim 1, wherein
the transmitting signal control section and the receiving signal control section each include:
a plurality of amplification sections or attenuation sections; and
a switch section for, in accordance with the received level detected by the received level detection section, selecting only one section from the plurality of amplification sections or attenuation sections, and determining a processing route for the radio signal received via the antenna.

**11.** The optical fiber radio transmission system according to claim 1, wherein
the transmitting signal control section and the receiving signal control section each include:
a plurality of amplification sections or attenuation sections; and
a switch section for, in accordance with the received level detected by the received level detection section, selecting at least two sections from the plurality of amplification sections or attenuation sections, connecting the selected sections in series, and determining a processing route for the radio signal received via the antenna.

**12.** The optical fiber radio transmission system according to claim 1, wherein the transmitting signal control section and the receiving signal control section vary an amount of amplification performed on the radio signal or an amount of attenuation performed on the radio signal in a stepwise manner in accordance with the received level.

**13.** The optical fiber radio transmission system according to claim 5, wherein the transmitting signal control section and the receiving signal control section vary an amount of amplification performed on the radio signal or an amount of attenuation performed on the radio signal in a stepwise manner in accordance with the received level.

**14.** The optical fiber radio transmission system according to claim 1, wherein the received level detection section outputs, to the transmitting signal control section and the control information sending section, a received level reflecting a predetermined hysteresis characteristic with respect to the detected received level of the radio signal.

**15.** The optical fiber radio transmission system according to claim 5, wherein the received level detection section outputs, to the transmitting signal control section and the control information sending section, a received level reflecting a predetermined hysteresis characteristic with respect to the detected received level of the radio signal.

**16.** The optical fiber radio transmission system according to claim 12, wherein the received level detection section outputs, to the transmitting signal control section and the control information sending section, a received level reflecting a predetermined hysteresis characteristic with respect to the detected received level of the radio signal.

**17.** The optical fiber radio transmission system according to claim 13, wherein the received level detection section outputs, to the transmitting signal control section and the control information sending section, a received level reflecting a predetermined hysteresis characteristic with respect to the detected received level of the radio signal.

**18.** A transmitting unit for converting a radio signal received via an antenna to an optical signal and sending the optical signal, the transmitting unit comprising:
a received level detection section for detecting a received level of a radio signal received via an antenna;
a transmitting signal control section for, in accordance with the received level detected by the received level detection section, controlling an amplification or attenuation process performed on the radio signal received via the antenna;
a control information sending section for associating control information relating to the received level detected by the received level detection section with the radio signal subjected to control by the transmitting signal control section and sending a resulting signal; and
an electrical to optical conversion section for converting, to an optical signal, the radio signal with which the control information is associated and transmitting the optical signal to a receiving unit via the optical fiber.

**19.** A receiving unit for receiving an optical signal sent from a transmitting unit and performing demodulation to obtain a radio signal received by the transmitting unit, the receiving unit comprising:
an optical to electrical conversion section for converting an optical signal transmitted from the transmitting unit via an optical fiber to an electrical signal;
a control information extraction section for extracting, from the electrical signal obtained from conversion by the optical to electrical conversion section, control information relating to a received level of a radio signal, the control information having been associated with the radio signal and sent by the transmitting unit; and
a receiving signal control section for, based on the received level obtained from the control information extracted by the control information extraction section, controlling an amplification or attenuation process performed on the electrical signal obtained from conversion by the optical to electrical conversion section so as to counteract against a process performed at the transmitting unit.

**20.** An optical fiber radio transmission method employed in a system including a transmitting unit for converting a radio signal received via an antenna to an optical signal and sending the optical signal, and a receiving unit for receiving the optical signal sent from the transmitting unit and performing demodulation to obtain the radio signal, the transmitting unit and the receiving unit being connected to each other via an optical fiber, wherein,
the transmitting unit includes:
a detection step for detecting a received level of a radio signal received via an antenna;
a transmitting signal control step for, in accordance with the received level detected by the detection step, controlling an amplification or attenuation process performed on the radio signal received via the antenna;
a sending step for associating control information relating to the received level detected by the detection step with the radio signal subjected to control by the transmitting signal control step and sending a resulting signal; and
an electrical to optical conversion step for converting, to an optical signal, the radio signal with which the control information is associated and transmitting the optical signal to the receiving unit via the optical fiber, and
the receiving unit includes:
an optical to electrical conversion step for converting the optical signal transmitted from the transmitting unit via the optical fiber to an electrical signal;
an extraction step for extracting, from the electrical signal obtained from conversion by the optical to electrical conversion step, the control information, which has been associated with the radio signal and sent by the transmitting unit; and
a receiving signal control step for, based on the received level obtained from the control information extracted by theextractionstep,controlling an amplification or attenuation process to be performed on the electrical signal obtained from conversion by the optical to electrical conversion step so as to counteract against the process performed by the transmitting signal control step.
